# EUROPEAN PATENT SPECIFICATION

(11) **EP 0 619 588 B1**
(45) Date of publication and mention of the grant of the patent: **09.07.1997**
(21) Application number: 94301609.7
(22) Date of filing: 08.03.1994
(51) Int. Cl.: H01H 13/10, H01H 11/00

(54) **Key switch device**
Tastschalter
Commutateur à touche

(30) Priority: 05.04.1993 JP 16680/93
(43) Date of publication of application: 12.10.1994
(73) Proprietor: BROTHER KOGYO KABUSHIKI KAISHA, Nagoya-shi, Aichi-ken (JP)
(72) Inventor: Kako, Mitsumasa, c/o Brother Kogyo K.K., Nagoya-shi, Aichi-ken (JP); Takagi,Takeyuki, c/o Brother Kogyo K.K., Nagoya-shi, Aichi-ken (JP); Mochizuki,Isao, c/o Brother Kogyo K.K., Nagoya-shi, Aichi-ken (JP)
(74) Representative: Senior, Alan Murray

(56) References cited:
- EP-A- 0 295 437
- EP-A- 0 354 312
- EP-A- 0 490 023
- EP-A- 0 543 649
- GB-A- 2 239 349
- PATENT ABSTRACTS OF JAPAN vol. 017, no. 668 (E-1473) 9 December 1993 & JP-A-05 225 858 (BROTHER) 3 September 1993

## Description

The invention relates to a key switch device and, more particularly, to a key switch device suitably used in a thin keyboard associated with a notebook-size word processor, notebook-size personal computer, etc.

In general, a conventional key switch device has a structure such that a circuit board in the form of an insulated film is sandwiched between a holder member and a switch supportina plate as described in EP-A-0,543,649 (which forms part of the state of the art under Article 54(3) EPC)

On the film circuit board are printed two kinds of switching circuits and a plurality of fixed contact patterns each consisting of two fixed contacts extending from the two kinds of switching circuits and combined in a comb-shaped manner. An inverted cup-shaped rubber spring is located at a position corresponding to each fixed contact pattern. A movable contact is provided in the rubber spring and, when the rubber spring is depressed, a switching operation is effected.

An actuator is provided in the holder member over the rubber spring, and a key top is mounted on the upper end of the actuator. When the key top is depressed by an operator, it is guided by the actuator to the upper portion of the rubber spring, and the rubber spring is depressed by the actuator. When an amount of depression of the rubber spring exceeds a certain limit, the movable contact in the rubber spring comes into contact with the fixed contact pattern, thereby short-circuiting the two fixed contacts and effecting the switching operation.

The switch supporting plate corresponds to a lower cover of a keyboard device and serves to enhance the rigidity of the keyboard device and improve the reliability of key entry.

Recent word processors, personal computers, etc. have been reduced in size, especially in thickness, weight, and cost. In association with this trend, a keyboard associated with such equipment is required to be reduced in size, thickness, and weight.

On the other hand, a movable portion of any key of the keyboard is required to have a good operability in view of human engineering (it is generally known that a minimum key stroke of 3 to 4 mm is required for an operator to recognize depression of the key). Accordingly, the above requirement must be satisfied with the minimum key stroke maintained.

In most cases, however, peripheral parts of the actuator and the holder member are formed mainly of a resin material by injection molding. Accordingly, a minimum wall thickness of 1.5 mm in each member is necessary. This connotes that the greater the number of parts to be laminated, the more difficult the reduction in thickness and, of course, the higher the weight.

Further, the conventional key switch device has three-layer structure consisting of the holder member, the film circuit board, and the switch supporting plate. Unless these three layers are laminated uniformly and closely, the reliability of response to key entry is deteriorated. As countermeasures against such a problem, it is known to suppress separation of these three layers at every key or at given intervals. However, much trouble is taken to ensure the suppression.

Several documents, for example EP-A-0,295,437, disclose a key switch device comprising: a substrate having an insulated upper surface; a fixed contact pattern applied to said insulated upper surface of said substrate and having at least a pair of fixed contacts; a key top; a moveable contact for performing a switching operation between said fixed contacts and moved by said vertical movement of said key top; guide supporting means for supporting said key top and guiding vertical movement of said key top, said guide supporting means including two rotatably supported link members each connected to a lower portion of said key top and to mounting means on the substrate, wherein the mounting means is formed separately of, and secured to, the substrate to which the fixed contact pattern is applied.

According to one aspect of the invention, there is provided a key switch device, comprising: a substrate having an insulated upper surface; a fixed contact pattern applied to said insulated upper surface of said substrate and having at least a pair of fixed contacts; a movable key top; a movable contact for performing a switching operation between said fixed contacts and moved by said vertical movement of said key top; and guide supporting means for supporting said key top and guiding vertical movement of said key top, said guide supporting means including at least two rotatably supported link members and being connected to a lower portion of said key top and to mounting means on the substrate, wherein said mounting means is formed as an integral part of said substrate.

Preferably said key top has connecting means adapted to be connected to said guide supporting member, said connecting means projecting from a lower surface of said key top at a position corresponding to said mounting means of said substrate; said two link members intersect each other and are mutually rotatably connected at a point of intersection, each of said two link members having opposite ends provided with support pins; said mounting means comprises a first group of mounting portions located on one side with respect to a vertical line passing said point of intersection and a second group of mounting portions located on the other side with respect to said vertical line; said connecting means of said key top comprises a first group of connecting portions located on one side with respect to said vertical line and a second group of connecting portions located on the other side with respect to said vertical line; said first groups of said mounting means and said connecting means having opening for rotatably supporting said support pins of said two link members on one side; and said second groups of said mounting means and said connecting means having grooves for slidably supporting said support pins of said two link members on the other side.

Advantageously, the mounting means is formed by pressing the substrate from a lower surface thereof, and forming a raised surface on the upper surface of the substrate where the support pins of the guide supporting member are in contact.

In operation, when the key top is depressed, the guide supporting member connected to the lower portion of the key top downwardly guides the key top. When the key top is guide supporting member to come into contact with the fixed contact pattern printed on the substrate, thus effecting the switching operation.

According to another aspect of the present invention, there is provided a method for producing a key switch, the method comprising: forming a substrate to have, as an integral part thereof, means for mounting a key supporting means; applying a fixed contact pattern to the substrate; mounting a movable contact onto the substrate; molding components of a key supporting means and a key top; assembling the components of the key supporting means; attaching the assembled key supporting means to said means for mounting a key supporting means; and attaching the key top to the key supporting means.

The hereinafter described embodiments of the invention can exhibit the following effects by integrating the substrate, the electrical circuit patterns, and the mounting portion for mounting the guide supporting member. That is, the number of parts can be reduced; the construction can be simplified; the keyboard can be reduced in size, especially in thickness; a sufficient key stroke can be ensured; and good key operability and reliable key entry can be obtained.

Further, the blanked holes resulting from the formation of the mounting portions of the substrate function as cooling holes to thereby effect radiation.

In order that the present invention may be better understood, the following description is given merely by way of example, with reference to the drawings in which:
Fig. 1 is a top plan view of a substrate of a key switch device in a preferred embodiment according to the present invention;
Fig. 2 is a sectional side view of the substrate shown in Fig. 1;
Fig. 3 is an exploded perspective view of the substrate and associated components in the preferred embodiment;
Fig. 4 is an exploded perspective view of the key switch device in the preferred embodiment;
Fig. 5 is a plan view of a first link member in the preferred embodiment;
Fig. 6 is a plan view of a second link member in the preferred embodiment;
Fig. 7 is a vertical sectional view of the key switch device in the preferred embodiment;
Fig. 8A is a plan view of a thick film printed on the substrate in the preferred embodiment;
Fig. 8B is a plan view of an alternative manner of printing the thick film on the substrate; and
Fig. 9 is an enlarged sectional view of a slidably mounting portion and its peripheral portion on the substrate in the preferred embodiment.

There will now be described, by way of example only, in detail a preferred embodiment according to the invention with reference to the drawings.

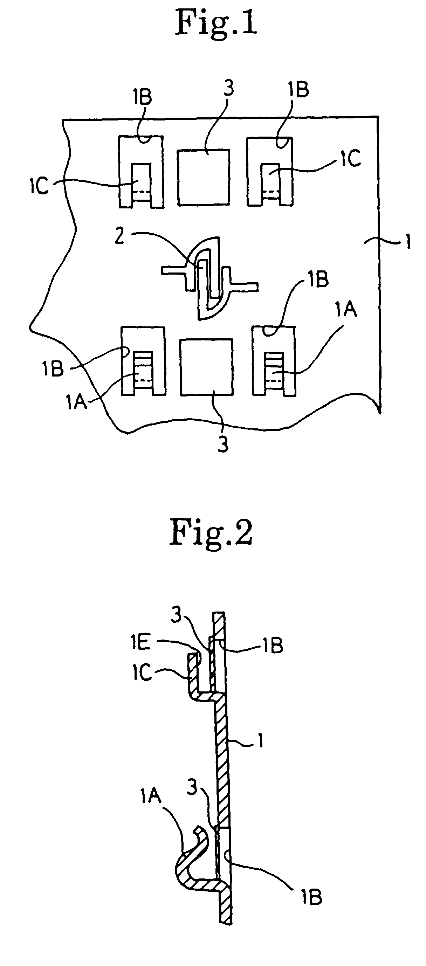

The construction of a key switch device in the preferred embodiment will be first described with reference to Figs. 1 through 7.

The key switch device is generally constructed of a substrate 1, a rubber spring 4, a key top 5, and a guide supporting member 6.

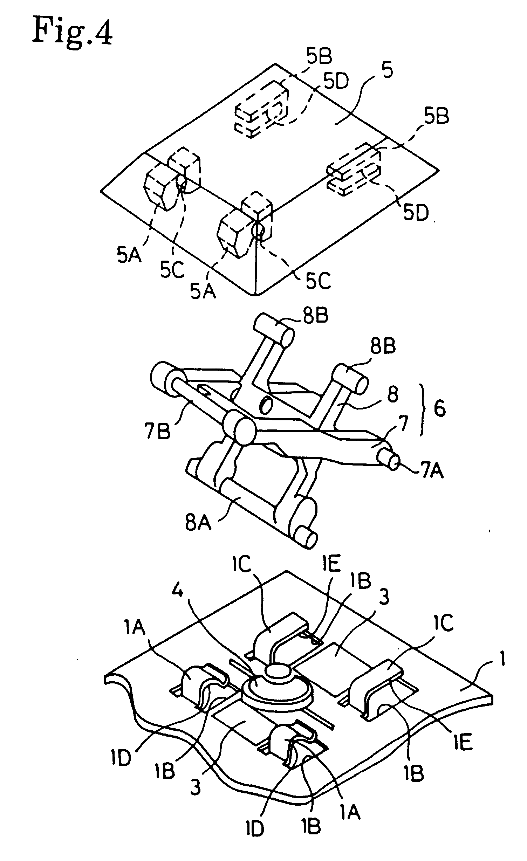

The key top 5 is formed of a synthetic resin, such as an ABS resin, and a character, such as an alphabetical letter, is formed on the upper surface of the key top 5 by printing or the like. As shown in Fig. 4, the lower surface of the key top 5 is provided integrally with two pairs of connecting portions 5A and 5B projecting downward.

Each connecting portion 5A is provided with an arcuate recess 5C for rotatably supporting a support shaft 7B formed at one end of a first link member 7, to be hereinafter described. The arcuate recess 5C opens at a lower end thereof, and the support shaft 7B, at one end of a first link member 7, is accordingly received from the lower opening end of the arcuate recess 5C.

Each connecting portion 5B is provided with an elongated recess 5D for horizontally slidably supporting a support pin 8B formed at one end of a second link member 8, to be hereinafter described. The elongated recess 5D opens at a longitudinal end thereof and the support pin 8B is received from the longitudinal opening end of the elongated recess 5D.

The guide supporting member 6, for vertically movably supporting the key top 5 and guiding the vertical movement thereof, is disposed under the key top 5. The guide supporting member 6 is constructed of the first link member 7 and the second link member 8. Both the first and second link members 7,8 are also formed of a synthetic resin, such as an ABS resin.

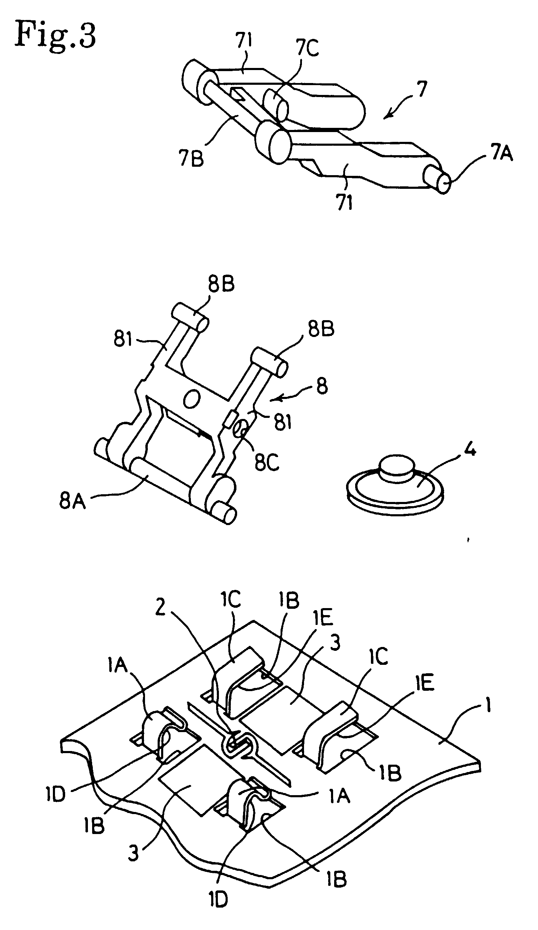

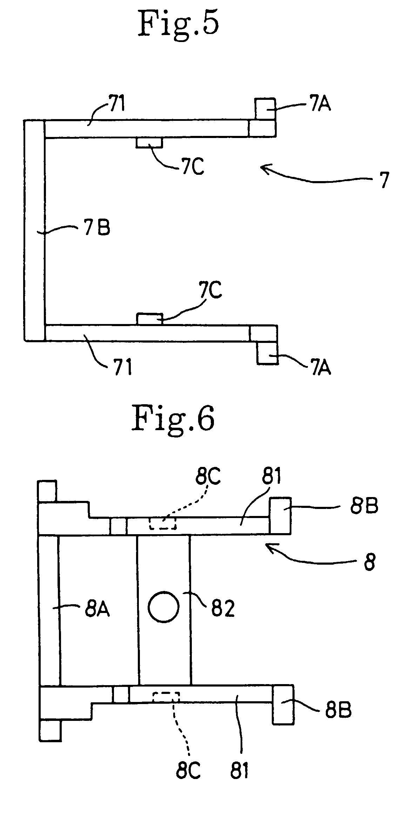

As shown in Figs. 3 and 5, the first link member 7 is formed in a U-shaped configuration as viewed in plan. The first link member 7 is integrally constructed of a pair of opposed side plates 71, a support shaft 7B extending between the side plates 71 at one end thereof, and a pair of support pins 7A projecting outward from the side plates 71 at the other end thereof. The support shaft 7B is received and rotatably supported in the arcuate recesses 5C of the two connecting portions 5A of the key top 5. The two support pins 7A are slidably supported to two mounting portions 1C of the substrate 1, to be hereinafter described, respectively. The inside surface of each side plate 71 is formed at its central portion with a connecting pin 7C projecting inward. The connecting pins 7C are rotatably supported in connecting holes 8C formed in the second link member 8 to be hereinafter described. As viewed in side elevation, the distance from the connecting pins 7C to the support pins 7A is equal to the distance from the connecting pins 7C to the support shaft 7B.

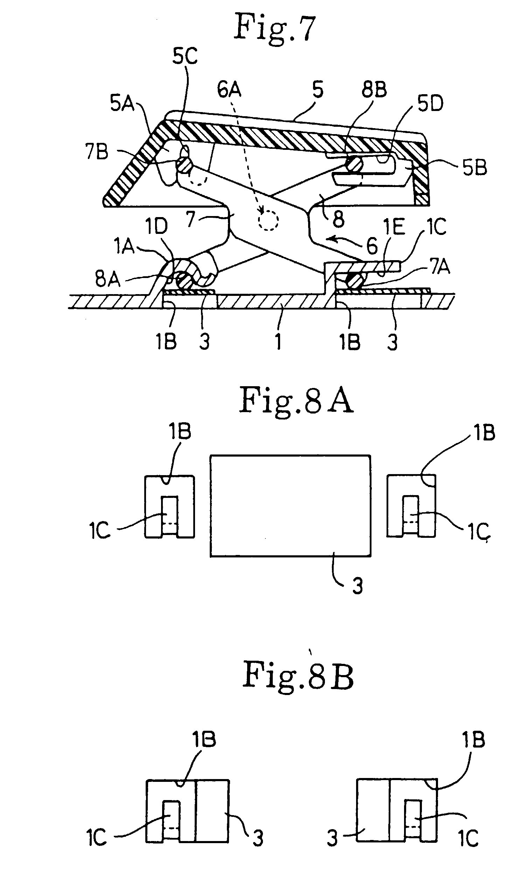

As shown in Figs. 3 and 6, the second link member 8 is integrally constructed of a pair of opposed side plates 81, a support shaft 8B at one end thereof extending between and projecting outward from the side plates 81 and a pair of support pins 8A projecting outward from the side plates 81 at the other end thereof. The support shaft 8A is rotatably supported at both ends thereof to two mounting portions 1A of the substrate 1, to be hereinafter described. The two support pins 8B are received in the elongated recesses 5D of the two connecting portions 5B of the key top 5, respectively, and slidably supported in the elongated recesses 5D. The outside surface of each side plate 81 is formed at its central portion with a connecting hole 8C for rotatably supporting a corresponding one of the connecting pins 7C of the side plates 71 of the first link member 7. Accordingly, the first and second link members 7,8 are rotatably connected together through the connecting pins 7C and the connecting holes 8C in such a manner as to intersect each other in an X-shaped configuration as shown in Fig. 7.

Referring to Fig. 7, reference numeral 6A denotes a fulcrum portion consisting of the connecting pins 7C of the first link member 7 and the connecting holes 8C of the second link member 8. As viewed in side elevation, the distance from the connecting holes 8C to the support pins 8B is equal to the distance from the connecting holes 8C to the support shaft 8A. Further, a push bar 82 extends between the side plates 81 at a central portion thereof. The push bar 82 is normally disposed over the rubber spring 4 and functions to depress the rubber spring 4 when the key top 5 is depressed to mutually rotate the first and second link members 7,8. Accordingly, when the key top 5 is depressed, the rubber spring 4 is depressed by the push bar 82 to thereby effect a switching operation.

As shown in Fig. 3, each side plate 71 of the first link member 7 is reduced in width at one end portion thereof as viewed in side elevation. Similarly, each side plate 81 of the second link member 8 is reduced in width at one end portion thereof as viewed in side elevation. With this structure, the end portions of the side plates 71 and 81 of the first and second link members 7 and 8 are prevented from coming into contact with each other during the course of depression of the key top 5. Accordingly, the depression of the key top 5 is not hindered over the stroke thereof so that a sufficient key stroke can be ensured.

The substrate 1 is formed of plastically deformable metal such as iron or aluminum. The surface of the substrate 1 is electrically insulated by under-resist printing. A first electrical circuit pattern for switching is printed with a conductive coating material, such as silver, on the electrically insulated surface of the substrate 1. A portion of the first electrical circuit pattern intersecting a second electrical circuit pattern is electrically insulated by printing. Over this insulating print, the second electrical circuit pattern is similarly printed with a conductive coating material. A plurality of hook-shaped fixed contacts extend from the two circuit patterns at fixed intervals, and each pair of the fixed contacts extending from the two circuit patterns are combined to form a fixed contact pattern 2.

The fixed contact patterns 2 and connectors (not shown) on the substrate 1 are covered with carbon coating, and the other portion of the printed surface of the substrate 1 is covered with resist printing.

The substrate 1 is formed integrally with a plurality of mounting portions 1A and 1C for mounting the guide supporting members 6 by pressing as will be hereinafter described. As shown in Figs. 1 and 3, a pair of the mounting portions 1A and a pair of the mounting portions 1C are arranged at the four corners of a phantom rectangle so as to surround the fixed contact pattern 2. Each mounting portion 1A is so configured as to rotatably engage with the ends of the support shaft 8A of the guide supporting member 6 and each mounting portion 1C is so configured as to horizontally slidably engage with one of the support pins 7A of the guide supporting member 6. The mounting portion 1A is raised from the substrate 1 and bent arcuately, as viewed in side elevation, in such a manner as to form an arcuate recess 1D permitting rotation of the support shaft 8A therewithin. The mounting portion 1C is also raised from the substrate 1 and bent in an L-shape, as viewed in side elevation, in such a manner as to form an elongated recess 1E permitting horizontal sliding of the support pin 7A. The fixed contact patterns 2 are regularly arranged in the longitudinal and transverse directions of the substrate 1. In correspondence therewith, the mounting portions 1A and 1C are regularly arranged in the longitudinal and transverse directions of the substrate 1.

As shown in Figs. 3 and 4, an inverted cup-shaped rubber spring 4, as a switching member, is disposed at a position corresponding to the fixed contact pattern 2 on the substrate 1. The rubber spring 4 includes therein a known movable contact. The upper surface of the rubber spring 4 is opposed at a central portion thereof to the push bar 82 of the guide supporting member 6. Accordingly, when a key top 5 is depressed, the fulcrum portion 6A is lowered, and the rubber spring 4 is depressed by the push bar 82. When an amount of depression of the rubber spring 4 exceeds a certain limit, the rubber spring 4 is buckled, and the fixed contact pattern 2 is short-circuited by the movable contact in the rubber spring 4.

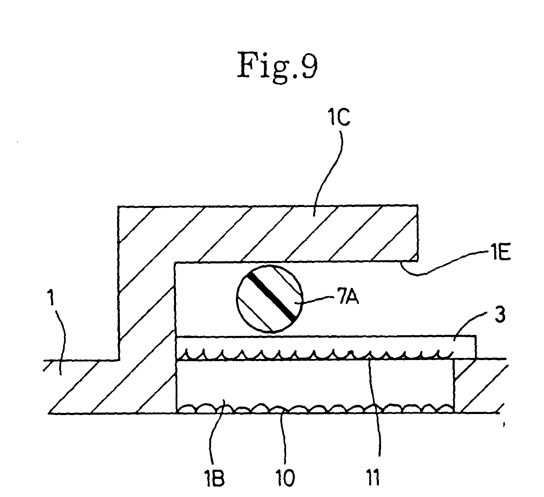

As shown in Figs. 1 and 2, thick films 3 are formed on the substrate 1. That is, the thick films 3 are formed between the two mounting portions 1A and the two mounting portions 1C of the substrate 1. Accordingly, as shown in Fig. 9, the support shaft 8A and the support pins 7A of the guide supporting member 6 are disposed on the thick films 3, so that the guide supporting member 6 is raised from the upper surface of the substrate 1 by the thickness of the thick films 3.

Now, a manufacturing method for the substrate 1 in the preferred embodiment will be described.

First, a sheet metal (solid sheet) of aluminum, iron, or other metal having similar characteristics forming the substrate 1 is prepared. The sheet metal is washed to remove any oil and stains sticking to the surface of the sheet metal. An under-resist is printed on the sheet metal, so as to electrically insulate the sheet metal. As the material of the under-resist printed on the sheet metal, an ultraviolet curing insulation screen ink such as ED452SS (the trade name by Nihon Acheson Co., Ltd.) may be used. The printing of the under-resist is effected by first applying the ultraviolet curing insulation screen ink to the surface of the washed sheet metal and then baking it in an ultraviolet light oven. The baking time and the baking temperature may be suitably modified according to the type of ink and sheet metal used. The printing of the under-resist is carried out preferably a number of times, e.g., three to four times.

Secondly, a first electrical circuit pattern for switching is printed on the insulated surface of the sheet metal by using a conductive coating material such as silver. As the material used for the first electrical circuit pattern to be printed on the insulated surface of the sheet metal, a conductive coating material such as ED6022SS (the trade name by Nihon Acheson Co., Ltd.) may be used. The printing of the first electrical circuit pattern is effected by first applying the conductive coating material to the insulated surface of the sheet metal to form a suitable pattern and then baking it in an oven. The baking time and the baking temperature may be suitably modified according to the type of conductive coating material and sheet metal used.

Thirdly, prior to printing a second electrical circuit pattern, a plurality of expected intersections between the first electrical circuit pattern and the second electrical circuit pattern are insulated with print. That is, a mask resist is selectively printed on the first electrical circuit pattern. As the material of the mask resist printed on the first electrical circuit pattern, an ultraviolet curing insulation screen ink such as ED452SS may be used. The printing of the mask resist is effected by first applying the ultraviolet curing insulation screen ink to the expected intersections between the first electrical circuit pattern and the second electrical circuit pattern and then baking it in an ultraviolet light oven. The baking time and the baking temperature may again be suitably modified according to the type of ink and sheet metal used. The printing of the mask resist is carried out preferably a number of times, e.g., three to four times.

Fourthly, the second electrical circuit pattern for switching is printed on the insulated surface of the sheet metal, that is, on the under-resist print, by using a conductive coating material such as silver. As the material of the second electrical circuit pattern to be printed, a conductive coating material such as ED6022SS may be used. The printing of the second electrical circuit pattern is effected by first applying the conductive coating material to the insulated surface of the sheet metal on which the mask resist has been formed to form a suitable pattern, and then baking it in an oven. The baking time and the baking temperature also may be suitably modified according to the type of conductive coating material and sheet metal to be used. As a result, a plurality of hook-shaped fixed contacts extend from the two circuit patterns at fixed intervals, and each pair of the fixed contacts are combined to form the fixed circuit pattern 2.

Fifthly, the fixed contact patterns 2 and connectors (not shown) on the substrate 1 are covered with a carbon coating. That is, a carbon pattern is printed on the fixed contact patterns 2 and the connectors. As the material of the carbon coating, a carbon coating material such as ED423SS (the trade name by Nihon Acheson Co., Ltd.) may be used. The printing of the carbon coating is effected by first applying the carbon coating material to the fixed contact patterns 2 and the connectors, and then baking it in an oven. The baking time and the baking temperature may be suitably modified according to the type of carbon coating material and sheet metal used.

Further, an over-resist is printed on the remaining portion of the substrate 1 other than the fixed contact patterns 2 and the connectors. As the material of the over-resist to be printed, an ultraviolet curing insulation screen ink such as ED452SS may be used. The printing of the over-resist is effected by first applying the ultraviolet curing insulation screen ink to the remaining portion of the substrate 1 other than the fixed contact patterns 2 and the connectors, and then baking it in an ultraviolet light oven. The baking time and the baking temperature may be suitably modified according to the kinds of the type of ink and sheet metal used.

The carbon pattern print and the over-resist print serve to prevent deterioration of the printed circuit due to oxidation. Further, a protective film may be attached on the over-resist printed surface of the sheet metal, so as to protect the printed circuit in plastic during further processing of the sheet metal to be carried out later.

Finally, the sheet metal on which the electrical circuit patterns and the resists have been printed is cut out. More specifically, the sheet metal is first cut out at predetermined positions to form a plurality of U-shaped blanked holes 1B and resultantly leave a plurality of hinge portions (corresponding to the mounting portions 1A and 1C). This work is called blanking. At the same time, the external shape of the substrate 1 is also formed by the blanking. Thus, as shown in Fig. 1, the U-shaped blanked holes 1B are regularly arranged in the longitudinal and transverse directions of the substrate 1. Then, the hinge portions are bent by pressing to thereby form the mounting portions 1A and 1C. In this way, the substrate 1 is completed.

In general, the blanking of a sheet metal is effected mostly by pressing from the viewpoint of cost reduction. Since the blanking by pressing employs a punch and die as a blanking die to shear and break the sheet metal, there is possibility of generation of shear droop 10 on the lower surface of the substrate 1 and burr 11 (about 100 µm in height) on the upper surface of the substrate 1 as shown in Fig. 9. In blanking the sheet metal from the lower surface thereof, the burr 11 is generated along the boundaries of the blanked holes 1B on the upper surface of the substrate 1. Accordingly, the burr 11 may hinder the support shaft 8A and the support pins 7A of the guide supporting member 6 from smoothly moving on the upper surface of the substrate 1.

To prevent such a hindrance of the burr 11, thick films 3 are formed on the upper surface of the substrate 1 between the two mounting portions 1A and between the two mounting portions 1C, that is, at suitable portions near the mounting portions 1A and 1C where the support shaft 8A and the support pins 7A come into contact as shown in Figs. 1 to 4 and 7 to 9. The formation of the thick films 3 is effected by first applying an ultraviolet curing insulation screen ink as mentioned above to necessary portions on the substrate 1 where the thick films 3 are to be formed, and then baking it in an ultraviolet light oven. This step is repeated a number of times, the number depending on the thickness desired. Thus, the thick films 3 are formed on the necessary portions on the substrate 1. As shown in Figs. 8A and 8B, the thick films 3 may be formed at the whole area or partial areas between the two mounting portions 1A and between the two mounting portions 1C.

Because of the presence of the thick films 3 on the upper surface of the substrate 1, the support shaft 8A and the support pins 7A are disposed on the thick films 3 and the guide supporting member 6 is raised from the upper surface of the substrate 1 by the thickness of the thick films 3. The thickness of the thick films 3 is set sufficiently greater than the height of the burr 11 so that the support shaft 8A and the support pins 7A can move smoothly without being hindered by the burr 11. Instead of specially forming the thick films 3, the number of times of the printing steps for the under-resist, the mask resist, and the over-resist mentioned may be increased to concurrently form necessary films corresponding to the thick films 3 on the substrate 1.

Alternatively, any raised surfaces rather than the thick films 3 may be formed near the mounting portions 1A and 1C by lightly pressing the substrate 1 from the lower surface thereof. In this manner, substantially the same effect as that of the thick films 3 can be obtained.

The operation of the key switch device having the above construction will now be described with reference to Fig. 7, a vertical sectional view of the key switch device. When the key top 5 is depressed, the support shaft 7B of the first link member 7 is rotated counterclockwise in the arcuate recesses 5C of the connecting portions 5A of the key top 5 and, simultaneously, the support pins 8B of the second link member 8 are slid horizontally (rightward as viewed in Fig. 7) in the elongated recesses 5D of the connecting portions 5B of the key top 5. At the same time, the support shaft 8A of the second link member 8 is rotated clockwise in the arcuate recesses 1D of the mounting portions 1A of the substrate 1 and, simultaneously, the support pins 7A of the first link member 7 are slid horizontally (rightward as viewed in Fig. 7) in the elongated recesses 1E of the mounting portions 1C of the substrate 1.

As a result, the fulcrum portion 6A mutually rotatably supporting the first and second link members 7,8 is lowered to gradually depress the rubber spring 4. When the amount of depression of the rubber spring 4 exceeds a certain limit, the rubber spring 4 is buckled. Accordingly, the fixed contact pattern 2 on the substrate 1 is short-circuited by the movable contact provided in the rubber spring 4, thus effecting a switching operation.

When the depression force applied to the key top 5 is removed, the fulcrum portion 6A of the first and second link members 7,8 is lifted by an elastic restoring force of the rubber spring 4. In association therewith, the support shafts 7B,8A and the support pins 7A,8B are operated reversely to the above. As a result, the key top 5 is returned to the original position.

In the above operation, the support shafts 7B,8A are only rotated in the respective arcuate recesses 5C,1D without horizontal movement. Therefore, the key top 5 is prevented from being horizontally moved, so that there is no possibility of the key top 5 contacting adjacent keys. The key top 5 is moved vertically with its horizontal condition being maintained.

The rubber spring 4 is substantially trapezoidal as viewed in side elevation, and an angle of inclination of the oblique sides depending upon the lengths of the parallel bases and the height of the trapezoid is decided according to the desired key touch. Further, the height of the trapezoid, i.e., the height of the rubber spring 4, is decided according to the key stroke, and the height is preferably set large. However, in consideration of the thickness of the key switch device as a whole, it is apparent that the size of the rubber spring 4 cannot be greatly increased.

Since the side plates 71,81 of the first and second link members 7,8 are reduced in width at the end portions as viewed in side elevation, the key stroke operation is not hindered during the vertical movement of the key top 5 and a sufficient key stroke can be ensured.

According to the key switch device of the invention, the complex construction, including the circuit board, the holder member, and the switch supporting plate found in the prior art can be simplified. Accordingly, the use of the key switch device according to the invention makes it possible to make a thinner keyboard and to increase the key stroke improving key to obtain reliable key entry. Furthermore, it is greatly advantageous in reduction in the number of parts, the ease in assembly, and the reduction in weight.

In most cases, a logic board, a memory device and a power supply in a portable computer are generally located under a keyboard and any measures taken against the heat generated from these elements must be taken into consideration. According to the key switch device of the invention, the substrate is provided with a plurality of holes (the blanked holes 1B). Since these holes function as cooling holes, effective heat radiation can be carried out. So from this point of view as well, the structure of the key switch device of the invention is improved.

In addition, the key switch device in the preferred embodiment can eliminate the need of guiding a key stem through a key holder portion. Accordingly, there is no possibility that a sliding noise may be generated between the key stem and the key holder portion upon depression of the key top as in the prior art key switch device. Further, there is no need to reduce the operational area of the key top and/or for depressing a central portion of the key top.

In the key switch device in the preferred embodiment, the support shaft 7B, engaged with the arcuate recesses 5C of the connecting portions 5A, and the support shaft 8A, engaged with the arcuate recesses 1D of the mounting portions 1A, are inhibited from horizontally moving but permitted only to rotate in the respective arcuate recesses 5C,1D upon depression of the key top 5. Accordingly, the key top 5 is prevented from moving horizontally to come into contact with any adjacent keys. Because of this, the structure of the key switch device is advantageous in that it provides good key operability and reliable key entry.

Further, since the substrate 1 is formed of a metal such as aluminum or iron, it can effectively shield any noise generated from circuits located under the substrate 1.

It is to be noted that the invention is not limited to the above preferred embodiment but various modifications and changes may be made without departing from the scope of the invention.

For example, the link members 7,8 in the preferred embodiment may be formed as the same kind of members combined in a pantograph configuration.

Further, while the rubber spring 4 is depressed by the fulcrum portion 6A of the link members 7,8 in the preferred embodiment, the rubber spring 4 may be depressed by another member provided on the link members 7,8 or on the key top 5.

Further, the substrate may be formed of a resin having some rigidity by injection molding or the like. In this case, the under-resist printing step (i.e., the step of forming an insulating layer on the substrate), the blanking step, and the bending step mentioned above are not necessary. In this case, with resin, the pad means may be integrally formed during the molding process.

## Claims

1. A key switch device, comprising:
a substrate (1) having an insulated upper surface;
a fixed contact pattern (2) applied to said insulated upper surface of said substrate and having at least a pair of fixed contacts;
a movable key top (5);
a movable contact (4) for performing a switching operation between said fixed contacts and moved by said vertical movement of said key top; and
guide supporting means (6) for supporting said key top (5) and guiding vertical movement of said key top (5), said guide supporting means (6) including at least two rotatably supported link members (7,8) and being connected to a lower portion of said key top (5) and to mounting means (1A, 1C) on the substrate,
wherein said mounting means (1A, 1C) is formed as an integral part of said substrate.

2. A key switch device according to claim 1, wherein said guide supporting means (6) comprises two rotatably supported link numbers (7,8) each connected to a lower portion of said key top (5) and to said mounting means (1A,1C) on the substrate.

3. A key switch device according to claim 2, wherein:
said key top (5) has connecting means (5A, 5B) adapted to be connected to said guide supporting member (6), said connecting means projecting from a lower surface of said key top at a position corresponding to said mounting means (1A, 1C) of said substrate (1);
said two link members (7, 8) intersect each other and are mutually rotatably connected at a point of intersection, each of said two link members (7,8) having opposite ends provided with support pins (7A, 7B, 8A, 8B);
said mounting means comprises a first group of mounting portions (1A) located on one side with respect to a vertical line passing said point of intersection and a second group of mounting portions (1C) located on the other side with respect to said vertical line;
said connecting means of said key top comprises a first group of connecting portions (5A) located on one side with respect to said vertical line and a second group of connecting portions (5B) located on the other side with respect to said vertical line;
said first groups (1C, 5B) of said mounting means and said connecting means having opening (1D, 5C) for rotatably supporting said support pins (8A, 7B) of said two link members (8, 7) on one side; and
said second groups (1C, 5B) of said mounting means and said connecting means having grooves (1E, 5D) for slidably supporting said support pins (7A, 8B) of said two link members (7, 8) on the other side.

4. A key switch device according to any one of claims 1 to 3, wherein said mounting means is formed by pressing said substrate (1) from a lower surface thereof and forming a raised surface (3) on said upper surface of said substrate where said support pins (3) of said guide supporting member (6) are in contact.

5. A key switch device according to claim 1 or 2, wherein said mounting means comprises four elements (1A, 1C) so positioned to define corners of a rectangle having said fixed contact pattern (2) contained therein.

6. A key switch device according to claim 5, wherein said movable contact is mounted on said substrate (1) between said four elements (1A, 1C) and below a centre portion of said guide supporting means (6).

7. A key switch device according to claims 5 or 6, further comprising pad means (3) positioned between a first pair (1A) of said four elements and also between a second pair (1C) of said four elements for facilitating unimpeded movement of said guide supporting means (6).

8. A key switch device according to claim 7, wherein said pad means (3) are raised portions of said substrate (1).

9. A key switch device according to claim 7, wherein said pad means (3) are insulating thick films adhered to said substrate.

10. A key switch device according to any one of claims 7 to 9, wherein each pad means (3) positioned between a pair (1A, 1C) of said four elements comprises to pads (3), one of said two pads immediately adjacent each element of said pair of elements.

11. A key switch device according to anyone of claims 1 to 10, wherein said substrate (1) is a metallic sheet and said mounting means (1A, 1C) are punch formed.

12. A key switch device according to any one of claims 1 to 10, wherein said substrate (1) is a plastic molded integrally with said mounting means (1A, 1C).

13. A key switch device according to any one of claims 1 to 10, wherein the substrate is formed of a deformable material.

14. A method for producing a key switch, the method comprising:
forming a substrate to have, as an integral part thereof, means (1A, 1C) for mounting a key supporting means (6);
applying a fixed contact pattern (2) to the substrate;
mounting a movable contact (4) onto the substrate (1);
molding components (7, 8) of a key supporting means (6) and a key top (5);
assembling the components (7, 8) of the key supporting means (6);
attaching the assembled key supporting means (6) to said means for mounting a key supporting means (6); and
attaching the key top (5) to the key supporting means (6).

15. A method according to claim 14, further comprising creating raised pad portions (3) on the substrate to provide a sliding surface for the key supporting member.

16. A method according to claim 15, wherein said step of forming a substrate and said step of creating raised portions are carried out together by a step of molding, from a resin, the substrate integrally with said means for mounting a key supporting member and said raised portions.

17. A method according to claim 15, wherein the substrate is formed of metal and said step of forming a substrate comprises:
punching out portions of the substrate to define said means (1A, 1C) for mounting a key supporting member; and
bending said means (1A,1C) for mounting a key supporting member.

18. A method according to claim 17, further comprising applying an insulating layer to the substrate prior to applying the fixed contact pattern, and wherein said step of creating raised portions is performed by coating a material having a low coefficient of friction on the substrate.

## Patentansprüche

1. Tastschalter mit:
einem Substrat (1) mit einer isolierten oberen Oberfläche;
einem festen Kontaktmuster (2), das auf die obere Oberfläche des Substrates aufgebracht ist und mindestens ein Paar von festen Kontakten aufweist;
einem bewegbaren Tastenoberteil (5);
einem bewegbaren Kontakt (4) zum Durchführen einer Schalttätigkeit zwischen den festen Kontakten, der durch die vertikale Bewegung des Tastenoberteiles bewegt wird; und
einem Führungstragmittel (6) zum Tragen des Tastenoberteiles (5) und Führen der vertikalen Bewegung des Tastenoberteiles (5), wobei das Führungstragmittel (6) mindestens zwei drehbar gelagerte Verbindungsteile (7, 8) aufweist und mit einem unteren Abschnitt des Tastenoberteiles (5) und mit einem Anbringungsmittel (1A, 1C) auf dem Substrat verbunden ist;
wobei das Anbringungsmittel (1A, 1C) als einstückiger Teil des Substrates gebildet ist.

2. Tastschalter nach Anspruch 1, bei dem das Führungstragmittel (6) zwei drehbar gelagerte Verbindungsteile (7, 8) aufweist, die jeweils mit einem unteren Abschnitt des Tastenoberteiles (5) und dem Anbringungsmittel (1A, 1C) auf dem Substrat verbunden sind.

3. Tastschalter nach Anspruch 2, bei dem
das Tastenoberteil (5) ein Verbindungsmittel (5A, 5B) aufweist, das so ausgelegt ist, daß es mit dem Führungstragteil (6) zu verbinden ist, wobei das Verbindungsmittel von einer unteren Oberfläche des Tastenoberteiles an einer Position entsprechend dem Anbringungsmittel (1A, 1C) des Substrates (1) vorsteht;
die zwei Verbindungsteile (7, 8) einander schneiden und an einem Schnittpunkt gegeneinander drehbar verbunden sind, wobei jedes der zwei Verbindungsteile (7, 8) entgegengesetzte Enden aufweist, die mit Tragzapfen (7A, 7B, 8A, 8B) versehen sind;
das Anbringungsmittel eine erste Gruppe von Anbringungsabschnitten (1A), die auf einer Seite in Bezug auf eine vertikale Linie angeordnet sind, die durch den Schnittpunkt geht, und eine zweite Gruppe von Verbindungsabschnitten (1C), die auf der anderen Seite in Bezug auf die vertikale Linie angeordnet sind, aufweist;
das Verbindungsmittel des Tastenoberteiles eine erste Gruppe von Verbindungsabschnitten (5A), die auf einer Seite in Bezug auf die vertikale Linie angeordnet sind, und eine zweite Gruppe von Verbindungsabschnitten (5B), die auf der anderen Seite in Bezug auf die vertikale Linie angeordnet sind, aufweist;
die erste Gruppe (1C, 5B) des Anbringungsmittels und des Verbindungsmittels Öffnungen (1D, 5C) zum drehbaren Lagern der Tragzapfen (8A, 7B) der zwei Verbindungsteile (8, 7) auf einer Seite aufweist; und
die zweite Gruppe (1C, 5B) des Anbringungsmittels und des Verbindungsmittels Rillen (1E, 5D) zum gleitenden Lagern der Tragzapfen (7A, 8B) der zwei Verbindungsteile (7, 8) auf der anderen Seite aufweist.

4. Tastschalter nach einem der Ansprüche 1 bis 3, bei dem das Anbringungsmittel durch Pressen des Substrates (1) von einer unteren Oberfläche davon und Bilden einer erhöhten Oberfläche (3) auf der oberen Oberfläche des Substrates, an der die Tragzapfen (3) des Führungstragteiles (6) in Kontakt sind, gebildet ist.

5. Tastschalter nach Anspruch 1 oder 2, bei dem das Anbringungsmittel vier Elemente (1A, 1C) aufweist, die so positioniert sind, daß sie die Ecken eines Rechteckes definieren, in dem das feste Kontaktmuster (2) enthalten ist.

6. Tastschalter nach Anspruch 5, bei dem der bewegbare Kontakt auf dem Substrat (1) zwischen den vier Elementen (1A, 1C) und unterhalb eines Mittelabschnittes des Führungstragteiles (6) angebracht ist.

7. Tastschalter nach Anspruch 5 oder 6, weiter mit einem Plättchenmittel (3), das zwischen einem ersten Paar (1A) der vier Elemente und auch zwischen einem zweiten Paar (1C) der vierten Elemente zum Erleichtern der unbeschränkten Bewegung des Führungstragmittels (6) positioniert ist.

8. Tastschalter nach Anspruch 7, bei dem das Plättchenmittel (3) erhöhte Abschnitte des Substrates (1) ist.

9. Tastschalter nach Anspruch 7, bei dem das Plättchenmittel (3) isolierte dicke Filme ist, die an dem Substrat anhaften.

10. Tastschalter nach einem der Ansprüche 7 bis 9, bei dem jedes Plättchenmittel (3), das zwischen einem Paar (1A, 1C) der vier Elemente positioniert ist, wobei eines der zwei Plättchen unmittelbar benachbart zu jedem Element und des Paares von Elementen ist.

11. Tastschalter nach einem der Ansprüche 1 bis 10, bei dem das Substrat (1) ein Metallblech ist und das Anbringungsmittel (1A, 1C) durch Stanzen gebildet ist.

12. Tastschalter nach einem der Ansprüche 1 bis 10, bei dem das Substrat (1) ein geformter Kunststoff ist, der einstückig mit dem Anbringungsmittel (1A, 1C) ist.

13. Tastschalter nach einem der Ansprüche 1 bis 10, bei dem das Substrat aus einem deformierbaren Material gebildet ist.

14. Verfahren zum Herstellen eines Tastschalters mit:
Bilden eines Substrates so, daß es als einstückiger Teil davon ein Mittel (1A, 1C) zum Anbringen eines Tasttragmittels (6) aufweist;
Aufbringen eines festen Kontaktmusters (2) auf das Substrat;
Anbringen eines bewegbaren Kontaktes (4) auf das Substrat (1);
Formen von Komponenten (7, 8) eines Tasttragmittels (6) und eines Tastoberteiles (5);
Zusammensetzen der Komponenten (7, 8) des Tasttragmittels (6);
Anbringen des zusammengesetzten Tasttragmittels (6) an dem Mittel zum Anbringen eines Tasttragmittels (6); und
Anbringen des Tastoberteiles (5) an dem Tasttragmittel (6).

15. Verfahren nach Anspruch 14 weiter mit:
Erschaffen erhöhter Plättchenabschnitte (3) auf dem Substrat zum Vorsehen einer Gleitoberfläche für das Tasttragteil.

16. Verfahren nach Anspruch 15, bei dem der Schritt des Bildens eines Substrates und der Schritt des Erschaffens erhöhter Abschnitte zusammen ausgeführt werden durch einen Schritt des Formens aus einem Harz des Substrates einstückig mit dem Mittel zum Anbringen eines Tasttragteiles und den erhöhten Abschnitten.

17. Verfahren nach Anspruch 15, bei dem das Substrat aus Metall gebildet wird und der Schritt des Bildens eines Substrates aufweist:
Ausstanzen von Abschnitten des Substrates zum Definieren des Mittels (1A, 1C) zum Anbringen eines Tasttragteiles und
Biegen des Mittels (1A, 1C) zum Anbringen eines Tasttragteiles.

18. Verfahren nach Anspruch 17, weiter mit
Aufbringen einer Isolierschicht auf das Substrat vor dem Aufbringen des festen Kontaktmusters, und bei dem der Schritt des Erzeugens erhöhter Abschnitte ausgeführt wird durch Beschichten des Substrates mit einem Material mit einem niedrigen Reibungskoeffizienten.

## Revendications

1. Commutateur à touche, comportant :
un substrat (1) ayant une surface supérieure isolée,
un motif de contact fixe (2) appliqué sur ladite surface supérieure isolée dudit substrat, ayant au moins deux contacts fixes,
une partie supérieure de touche (5) mobile,
un contact mobile (4) pour réaliser une opération de commutation entre lesdits contacts fixes et déplacé par ledit mouvement vertical de ladite partie supérieure de touche, et
des moyens de support formant guide (6) pour supporter ladite partie supérieure de touche (5) et guider le mouvement vertical de ladite partie supérieure de touche (5), lesdits moyens de support formant guide (6) comportant au moins deux éléments de liaison supportés de manière rotative (7, 8) et reliés à une partie inférieure de ladite partie supérieure de touche (5) et à des moyens de montage (1A, 1C) situés sur le substrat,
dans lequel lesdits moyens de montage (1A, 1C) sont formés en tant que parties venues de matière avec ledit substrat.

2. Commutateur à touche selon la revendication 1, dans lequel lesdits moyens de support formant guide (6) comportent deux éléments de liaison supportés rotatifs (7, 8) connectés, chacun, à une partie inférieure de ladite partie supérieure de touche (5) et auxdits moyens de montage (1A, 1C) situés sur le substrat.

3. Commutateur à touche selon la revendication 2, dans lequel :
ladite partie supérieure de touche (5) comporte des moyens de connexion (5A, 5B) adaptés pour être reliés auxdits moyens de support formant guide (6), lesdits moyens de connexion faisant saillie à partir de la surface inférieure de ladite partie supérieure de touche au niveau d'une position correspondant auxdits moyens de montage (1A, 1C) dudit substrat (1),
lesdits éléments de liaison (7, 8) se recoupent l'un l'autre et sont reliés mutuellement de manière rotative au niveau du point d'intersection, chacun desdits deux éléments de liaison (7, 8) ayant des extrémités opposées munies d'axes de support (7A, 7B, 8A, 8B),
lesdits moyens de montage comportent un premier groupe de parties de montage (1A) situé sur un premier côté par rapport à une ligne verticale passant par ledit point d'intersection et un second groupe de parties de montage (1C) situé sur l'autre côté par rapport à ladite ligne verticale,
lesdits moyens de connexion de ladite partie supérieure de touche comporte un premier groupe de parties de liaison (5A) situé sur un premier côté par rapport à ladite ligne verticale et un second groupe de parties de liaison (5B) situé sur l'autre côté par rapport à ladite ligne verticale,
lesdits premiers groupes (1C, 5B) desdits moyens de montage et desdits moyens de connexion ayant une ouverture (1D, 5C) pour supporter de manière rotative lesdits axes de support (8A, 7B) desdits deux éléments de liaison (8, 7) sur un premier côté, et
lesdits seconds groupes (1C, 5B) desdits moyens de montage et desdits moyens de connexion ayant des gorges (1E, 5D) pour supporter de manière coulissante lesdits axes de support (7A, 8B) desdits deux éléments de liaison (7, 8) sur l'autre côté.

4. Commutateur à touche selon l'une quelconque des revendications 1 à 3, dans lequel lesdits moyens de montage sont formés par emboutissage dudit substrat (1) à partir d'une surface inférieure de celui-ci et mise en forme d'une surface surélevée (3) sur ladite surface supérieure dudit substrat, où lesdits axes de support dudit élément de support formant guide (6) sont en contact.

5. Commutateur à touche selon la revendication 1 ou 2, dans lequel lesdits moyens de montage comportent quatre éléments (1A, 1C) positionnés de manière à définir les coins d'un rectangle ayant ladite configuration de contact fixe (2) contenue dans celui-ci.

6. Commutateur à touche selon la revendication 5, dans lequel ledit contact mobile est monté sur ledit substrat (1) entre lesdits quatre éléments (1A, 1C) et en dessous d'une partie centrale desdits moyens de support formant guide (6).

7. Commutateur à touche selon la revendication 5 ou 6, comportant de plus des moyens (3) formant patin positionnés entre une première paire (1A) desdits quatre éléments et aussi entre une seconde paire (1C) desdits quatre éléments pour faciliter un mouvement non-gêné desdits moyens de support formant guide (6).

8. Commutateur à touche selon la revendication 7, dans lequel lesdits moyens formant patin (3) sont des parties surélevées dudit substrat (1).

9. Commutateur à touche selon la revendication 7, dans lequel lesdits moyens formant patin (3) sont des films isolants épais collés sur ledit substrat.

10. Commutateur à touche selon l'une quelconque des revendications 7 à 9, dans lequel chacun des moyens formant patin (3) positionnés entre une paire (1A, 1C) desdits quatre éléments comporte deux patins (3), un desdits deux patins étant immédiatement adjacent à chaque élément de ladite paire d'éléments.

11. Commutateur à touche selon l'une quelconque des revendications 1 à 11, dans lequel ledit substrat (1) est une feuille métallique et lesdits moyens de montage (1A, 1C) sont formés par poinçonnage.

12. Commutateur à touche selon l'une quelconque des revendications 1 à 10, dans lequel ledit substrat (1) est une matière plastique moulée en une seule pièce avec lesdits moyens de montage (1A, 1C).

13. Commutateur à touche selon l'une quelconque des revendications 1 à 10, dans lequel le substrat est formé d'une matière déformable.

14. Procédé de fabrication d'un commutateur à touche, le procédé comportant les étapes consistant à :
former un substrat pour avoir, en tant que partie venue de matière avec celui-ci, des moyens (1A, 1C) pour monter des moyens de support de touche (6),
appliquer un motif de contact fixe sur le substrat,
monter un contact mobile (4) sur le substrat (1),
mouler des composants (7, 8) de moyens de support de touche (6) et une partie supérieure de couche (5),
assembler les composants (7, 8) des moyens de support de touche (6)
fixer les moyens de support de touche assemblés (6) sur lesdits moyens pour monter des moyens de support de touche (6), et
fixer la partie supérieure de touche (5) sur les moyens de support de touche (6).

15. Procédé selon la revendication 14, consistant de plus à créer des parties (3) formant patin surélevé sur le substrat pour fournir une surface de coulissement pour l'élément de support de touche.

16. Procédé selon la revendication 15, dans lequel ladite étape de formation d'un substrat et ladite étape de création de partie surélevée sont exécutées ensemble par une étape de moulage, à partir d'une résine, du substrat en une seule pièce avec lesdits moyens pour monter un élément de support de touche et lesdites parties surélevées.

17. Procédé selon la revendication 15, dans lequel le substrat est formé d'un métal et ladite étape de formation d'un substrat consiste à :
poinçonner des parties du substrat pour définir lesdits moyens (1A, 1C) pour monter un élément de support de touche, et
incurver lesdits moyens (1A, 1C) pour monter un élément de support de touche.

18. Procédé selon la revendication 17, consistant de plus à appliquer une couche isolante sur le substrat avant d'appliquer le motif de contact fixe, et dans lequel ladite étape de création de parties surélevées est réalisée par revêtement d'un matériau ayant un faible coefficient de friction sur le substrat.
